(19) Europäisches Patentamt
European Patent Office
Office européen des brevets

(11) **EP 3 362 835 B1**

(12) **EUROPÄISCHE PATENTSCHRIFT**

(45) Veröffentlichungstag und Bekanntmachung des Hinweises auf die Patenterteilung:
**29.11.2023 Patentblatt 2023/48**

(21) Anmeldenummer: **16790522.3**

(22) Anmeldetag: **28.10.2016**

(51) Internationale Patentklassifikation (IPC):
*G02B 13/22* (2006.01)    *G03F 7/20* (2006.01)
*B22F 12/45* (2021.01)    *B22F 12/44* (2021.01)
*B22F 10/28* (2021.01)    *B41J 2/45* (2006.01)
*G03F 7/00* (2006.01)

(52) Gemeinsame Patentklassifikation (CPC):
**B41J 2/451; B22F 10/28; B22F 12/44; B22F 12/45; G02B 13/22; G03F 7/2053; G03F 7/2055; G03F 7/70416;** B22F 12/41; B22F 12/47; Y02P 10/25

(86) Internationale Anmeldenummer:
**PCT/EP2016/001798**

(87) Internationale Veröffentlichungsnummer:
**WO 2017/076493 (11.05.2017 Gazette 2017/19)**

(54) **BELICHTEROPTIK UND VORRICHTUNG ZUM HERSTELLEN EINES DREIDIMENSIONALEN OBJEKTS**

EXPOSURE OPTICAL SYSTEM AND DEVICE FOR PRODUCING A THREE-DIMENSIONAL OBJECT

OPTIQUE D'EXPOSITION ET DISPOSITIF DE FABRICATION D'UN OBJET TRIDIMENSIONNEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.11.2015 DE 102015221623**

(43) Veröffentlichungstag der Anmeldung:
**22.08.2018 Patentblatt 2018/34**

(73) Patentinhaber: **EOS GmbH Electro Optical Systems**
**82152 Krailling (DE)**

(72) Erfinder:
• **PERRET, Hans**
**81543 München (DE)**
• **GRONENBORN, Stephan**
**52066 Aachen (DE)**

(74) Vertreter: **Prüfer & Partner mbB**
**Patentanwälte · Rechtsanwälte**
**Sohnckestraße 12**
**81479 München (DE)**

(56) Entgegenhaltungen:
**EP-A2- 0 601 485    WO-A1-2015/091485**
**WO-A2-2005/114643    JP-A- 2000 321 528**
**JP-A- 2002 033 539**

## Beschreibung

Die vorliegende Erfindung bezieht sich auf eine Vorrichtung zum Herstellen eines dreidimensionalen Objekts durch schichtweises Aufbringen und selektives Verfestigen eines Aufbaumaterials, insbesondere auf eine in der Vorrichtung enthaltenen Belichteroptik.

Vorrichtungen dieser Art werden beispielsweise beim Rapid Prototyping, Rapid Tooling oder Additive Manufacturing verwendet. Ein Beispiel eines solchen Verfahrens ist unter dem Namen "Selektives Lasersintern oder Laserschmelzen" bekannt. Dabei wird wiederholt eine dünne Schicht eines Aufbaumaterials aufgebracht und das Aufbaumaterial in jeder Schicht durch selektives Bestrahlen mit einem Laserstrahl selektiv verfestigt.

Um den Verfestigungsvorgang zu beschleunigen, umfasst die aus der WO 2015/091485 bekannte Vorrichtung Halbleiterlaser, welche als Laserarrays in Modulen gruppiert sind und eine flächige Laserstrahlung aussenden. Durch selektives flächiges Bestrahlen von dünnen Schichten eines Aufbaumaterials, die auf ein Baufeld aufgebracht werden, wird das Aufbaumaterial an den dem Querschnitt des herzustellenden Objekts in der jeweiligen Schicht entsprechenden Stellen verfestigt.

Zum Abbilden der von den Modulen ausgesandten Laserstrahlung ist eine Optik vorgesehen, welche zwischen der Strahlungsquelle und dem Baufeld, auf welchem die Verfestigung des Aufbaumaterials erfolgt, angeordnet ist. Die Optik umfasst eine über dem Baufeld angeordnete Linse zum Abbilden der Laserstrahlung auf das Baufeld.

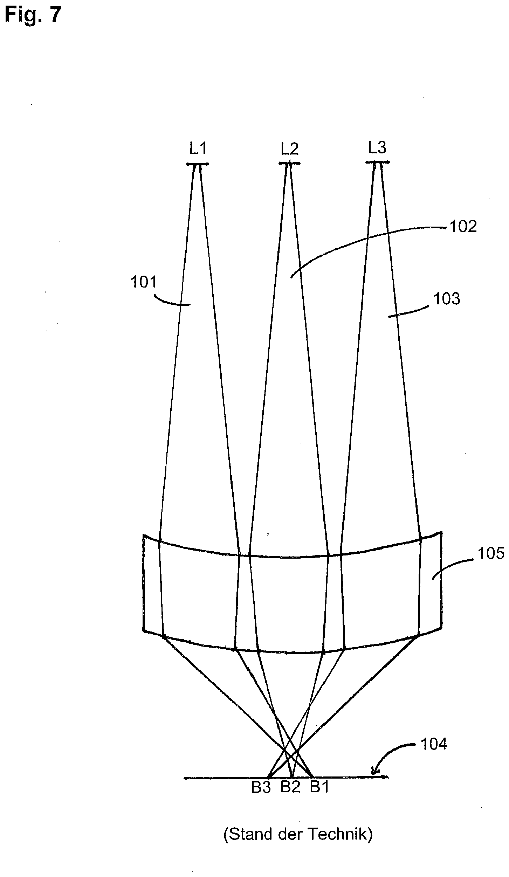

Fig. 7 zeigt den Strahlengang einer solchen Linsenanordnung. Drei Laserelemente L1-L3 eines Laserarrays senden gebündelte Strahlung 101-103 in Form von Strahlkegeln in Richtung zu dem Baufeld 104. Diese Strahlkegel werden von einer Linse 105 fokussiert und erzeugen Bildpunkte B1-B3 auf dem Baufeld, die verkleinerte Abbildungen der Laserelemente L1-L3 sind. Da die einzelnen Laser der Arrays verkleinert auf das Baufeld abgebildet werden sollen, ist die Linse 105 wesentlich näher an dem Baufeld 104 angeordnet als an den Laserdioden L1-L3, was zu stark geneigtem Strahleinfall in den Randbereichen mit verringertem Flächenenergieeintrag führen kann. Zudem ist die Abbildungstreue abhängig von dem Abstand der Strahlungsquelle zu dem Baufeld.

Die Aufgabe der vorliegenden Erfindung besteht darin, eine alternative bzw. verbesserte Belichteroptik für eine derartige Vorrichtung bereitzustellen. Insbesondere soll eine Abbildung der in einer Fläche ausgesandten Strahlkegel auf eine Arbeitsfläche bei möglichst kleinen geometrischen Abbildungsfehlern ermöglicht werden.

Diese Aufgabe wird gelöst durch eine Vorrichtung gemäß Anspruch 1 und die Verwendung einer Vorrichtung gemäß Anspruch 13 . Weiterbildungen der Erfindung sind jeweils in den Unteransprüchen angegeben. Dabei kann die Vorrichtung auch durch die untenstehenden bzw. in den Unteransprüchen ausgeführten Merkmale der Belichteroptik weitergebildet sein oder umgekehrt. Analoges gilt für die entsprechende erfindungsgemäße Verwendung.

Die erfindungsgemäße Belichteroptik dient als Aus- und/oder Nachrüstoptik für eine Vorrichtung zum Herstellen eines dreidimensionalen Objektes durch selektives schichtweises Verfestigen von Aufbaumaterial an dem Querschnitt des herzustellenden Objektes in der jeweiligen Schicht entsprechenden Stellen mittels Einwirkung elektromagnetischer Strahlung, wobei die Vorrichtung eine Strahlungsquelle umfasst, welche in der Lage ist, eine elektromagnetische Strahlung auszusenden, die geeignet ist, beim Auftreffen auf die dem Querschnitt des herzustellenden Objektes entsprechenden Stellen einer in einer Arbeitsfläche der Vorrichtung aufgebrachten Schicht des Aufbaumaterials die Verfestigung des Aufbaumaterials an diesen Stellen zu bewirken. Die Belichteroptik umfasst zumindest ein erstes objektseitiges Linsensystem mit einer ersten Brennweite $f_1$ und ein zweites bildseitiges Linsensystem mit einer zweiten Brennweite $f_2$ welche in dem Strahlengang der von der Strahlungsquelle ausgesandten Strahlung angeordnet sind. Die Brennebene des ersten Linsensystems und die Brennebene des zweiten Linsensystems fallen in einer Ebene zwischen den beiden Linsensystemen zusammen und die Brennweite $f_1$ des ersten Linsensystems ist gleich groß oder größer als die Brennweite $f_2$ des zweiten Linsensystems. Die Belichteroptik ist so ausgebildet und anordbar, dass die elektromagnetische Strahlung im Wesentlichen senkrecht auf die Arbeitsfläche auftrifft.

Diese bi-telezentrische Abbildung ermöglicht das Abbilden der von der Strahlungsquelle ausgesandten flächigen Strahlung auf die Arbeitsfläche. Dadurch ist es möglich, das Aufbaumaterial selektiv an dem Querschnitt des Objekts in der jeweiligen Schicht entsprechenden Stellen schnell und auf einfache Art und Weise zu verfestigen. Durch die bi-telezentrische Abbildung ist der Abbildungsmaßstab und damit die Größe der belichteten Fläche weitestgehend unabhängig von dem Abstand der Lichtquelle zu der Arbeitsfläche. Zudem wird eine geringe optische Verzeichnung erzielt, was ein laterales Anordnen mehrerer Module mit zugehöriger Optik ermöglicht. Da die Laserstrahlung im Wesentlichen senkrecht auf die Arbeitsfläche auftrifft, ist eine im Wesentlich gleichmäßige Intensitätsverteilung der Laserstrahlung auf der zu belichtenden Fläche gewährleistet.

Vorzugsweise weist das zweite Linsensystem zumindest zwei gekrümmte Oberflächen auf, von denen zumindest eine asphärisch und bevorzugt konkav ist. Die asphärische Oberfläche dient z. B. der Korrektur von geometrischen Abbildungsfehlern wie beispielsweise optischer Verzeichnung oder Bildfeldwölbung.

Vorzugsweise weist das zweite Linsensystem zumindest zwei gekrümmte Oberflächen auf und der minimale Abstand und/oder die Mittendicke zwischen den beiden Oberflächen ist größer als ein Viertel, bevorzugt größer als die Hälfte der Brennweite $f_2$. Dadurch liegt die Hauptebene des zweiten Linsensystems nahe an der der Arbeitsfläche zugewandten Oberfläche des Linsensystems. Vorzugsweise weist das zweite Linsensystem zumindest zwei gekrümmte Oberflächen auf, von denen zumindest eine sphärisch ist und für deren Krümmungsradius R gilt:

$$R < f_2 * (n-1)$$

wobei $f_2$ die Brennweite des zweiten Linsensystems ist und n der Brechungsindex des Linsenmaterials. Dadurch ist die Brennweite der sphärischen Oberfläche kleiner als die Brennweite des gesamten zweiten Linsensystems.

Das erste Linsensystem weist vorzugsweise zwei sphärische Oberflächen oder eine ebene und eine sphärische Oberfläche auf. Dadurch wird die von der Strahlungsquelle ausgesandte parallele Strahlung durch das erste Linsensystem in einer Brennebene gesammelt.

Vorzugsweise entspricht der Quotient $f_2/f_1$ einem gewählten Abbildungsmaßstab. Dadurch kann u. A. die Größe der zu belichtende Fläche und damit auch der Flächenenergieeintrag auf einfache Art und Weise festgelegt werden.

Vorzugsweise weist der Quotient $f_2/f_1$ einen Wert von mindestens 0,05, bevorzugt mindestens 0,1 und besonders bevorzugt mindestens 0,15 und/oder von höchstens 1, bevorzugt höchstens 0,5 und besonders bevorzugt höchstens 0,3 auf. Die verkleinerte Abbildung bewirkt eine kleinere Pixelgröße und einen größeren Flächenenergieeintrag.

Vorzugsweise ist mindestens eines, weiter bevorzugt jedes, der beiden Linsensysteme aus einer einzelnen Linse gebildet. Dies erleichtert das Einbringen und Ausrichten der Linsen in der Vorrichtung.

Alternativ kann zumindest eines der Linsensysteme aus zumindest zwei Linsen gebildet sein. Insbesondere bei Verwendung eines Linsensystems mit zwei verschieden gekrümmten Flächen kann dieses einfacher hergestellt und verschieden gekrümmte Flächen je nach Bedarf kombiniert werden.

Die erfindungsgemäße Vorrichtung dient zum Herstellen eines dreidimensionalen Objekts durch selektives schichtweises Verfestigen von Aufbaumaterial an dem Querschnitt des herzustellenden Objekts in der jeweiligen Schicht entsprechenden Stellen mittels Einwirkung elektromagnetischer Strahlung und umfasst eine Strahlungsquelle, welche geeignet ist elektromagnetische Strahlung auszusenden. Die Verfestigung des Aufbaumaterials erfolgt in einer Arbeitsfläche und die Vorrichtung weist eine Belichteroptik auf mit zumindest einem ersten objektseitigen Linsensystem mit einer ersten Brennweite $f_1$ und einem zweiten bildseitigen Linsensystem mit einer zweiten Brennweite $f_2$ welche in dem Strahlengang der von der Strahlungsquelle ausgesandten Strahlung angeordnet sind. Die Brennebene des ersten Linsensystems und die Brennebene des zweiten Linsensystems fallen in einer Ebene zwischen den beiden Linsensystemen zusammen, die Brennweite $f_1$ des ersten Linsensystems ist gleich groß oder größer ist als die Brennweite $f_2$ des zweiten Linsensystems und die Belichteroptik ist so ausgebildet und anordbar, dass die elektromagnetische Strahlung im Wesentlichen senkrecht auf die Arbeitsfläche auftrifft. Damit lassen sich die oben für die Belichteroptik aufgeführten Wirkungen in einer Vorrichtung zum Herstellen eines dreidimensionalen Objekts, die die Belichteroptik umfasst, erzielen.

Vorzugsweise ist die Strahlungsquelle von Lasern, insbesondere VCSELn, gebildet, welche in Modulen gruppiert sind, und jedes Modul umfasst vorzugsweise zumindest zwei Laser-Arrays. Durch diese Anordnung ist eine Strahlungsquelle zum flächigen Belichten realisierbar. Die Verwendung von VCSELn ermöglicht ein schnelles Schalten der Laser. Unter VCSELn werden neben den hinlänglich bekannten Oberflächenemittern (Englisch: verticalcavity surface-emitting lasers - VCSEL) analog zur auch hier zugrunde gelegten Definition in der WO 2015/091485 u. A. auch VECSELn (optisch gepumpte Halbleiterlaser - vertical external cavity surface emitting lasers) verstanden. Ganz allgemein wird der Inhalt der WO 2015/091485 als Teil der Offenbarung der vorliegenden Anmeldung verstanden.

Erfindungsgemäß ist die Belichteroptik in einer Prozesskammer der Vorrichtung bewegbar angeordnet. Dadurch ist die Belichteroptik entsprechend einer aktuellen Verfestigungsstelle über die Arbeitsfläche verfahrbar.

Vorzugsweise ist die Brennweite $f_2$ des zweiten Linsensystems kleiner als ein minimaler freier Arbeitsabstand. Dies definiert einen Abstand zwischen der Belichteroptik und der Arbeitsfläche.

Vorzugsweise sind die Strahlungsquelle und/oder eine zwischen der Strahlungsquelle und der Belichteroptik angeordnete weitere Belichteroptik derart, dass die Strahlung auf das erste Linsensystem im Wesentlichen senkrecht auftrifft. Durch die telezentrische Abbildung treffen die Laserstrahlen als parallele Strahlen mit konstantem Abstand zwischen den Strahlachsen auf die Arbeitsfläche auf.

Die Verwendung einer erfindungsgemäßen Belichteroptik dient zur Herstellung eines dreidimensionalen Objektes in einer Vorrichtung durch selektives schichtweises Verfestigen von Aufbaumaterial an dem Querschnitt des herzustellenden Objektes in der jeweiligen Schicht entsprechenden Stellen mittels Einwirkung elektromagnetischer Strahlung, wobei die Vorrichtung eine Strahlungsquelle umfasst, welche geeignet ist elektromagnetische Strahlung auszusenden und die Verfestigung des Aufbaumaterials in einer Arbeitsfläche erfolgt. Damit lassen sich die oben für die Belichteroptik und die Vorrichtung aufgeführten Wirkungen durch die Verwendung der Belichteroptik erzielen.

Weitere Merkmale und Zweckmäßigkeiten der Erfindung ergeben sich aus der Beschreibung von Ausführungsbeispielen anhand der beigefügten Zeichnungen.

Fig. 1 ist eine schematische, teilweise im Schnitt dargestellte Ansicht einer Vorrichtung zum schichtweisen Herstellen eines dreidimensionalen Objekts gemäß einer Ausführungsform der vorliegenden Erfindung.

Fig. 2 ist eine schematische Draufsicht auf die in Fig. 1 gezeigten Vorrichtung.

Fig. 3 ist eine schematische Schnittansicht des in Fig. 1 gezeigten Lasermoduls.

Fig. 4 ist eine schematische Ansicht der Anordnung der Linsen und der Strahlengänge einer in der Vorrichtung verwendeten Belichteroptik.

Fig. 5 ist eine schematische Schnittansicht der ersten Linse aus Fig. 4.

Fig. 6 ist eine schematische Schnittansicht der zweiten Linse aus Fig. 4.

Fig. 7 ist eine schematische Ansicht der Anordnung einer Linse und der Strahlengänge einer im Stand der Technik verwendeten Belichteroptik.

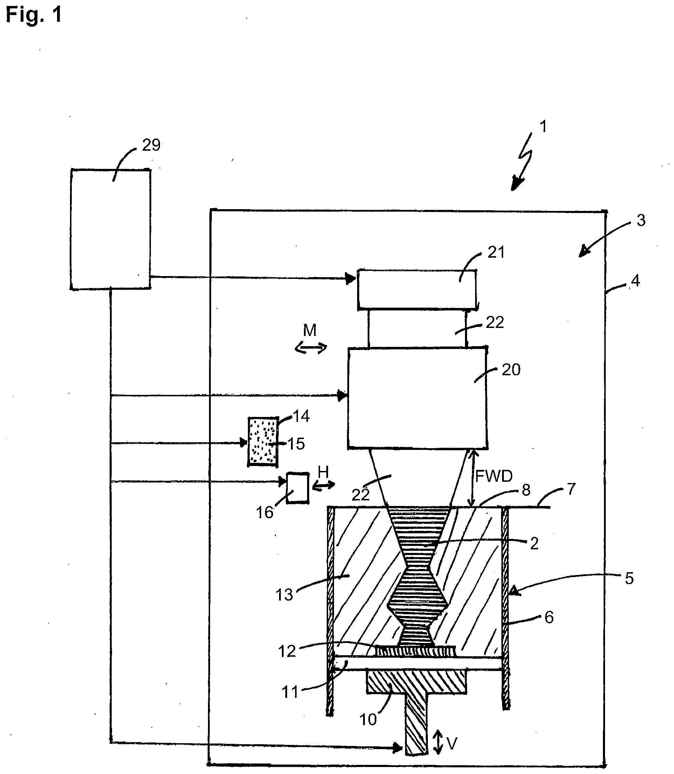

Im Folgenden wird mit Bezug auf Fig. 1 eine Vorrichtung 1 gemäß einer Ausführungsform der vorliegenden Erfindung beschrieben. Die in Fig. 1 dargestellte Vorrichtung ist eine Lasersinter- oder Laserschmelzvorrichtung 1. Zum Aufbauen eines Objekts 2 enthält sie eine Prozesskammer 3 mit einer Kammerwandung 4.

In der Prozesskammer 3 ist ein nach oben offener Behälter 5 mit einer Behälterwandung 6 angeordnet. Durch die obere Öffnung des Behälters 5 ist eine Arbeitsfläche 7 definiert, wobei die Arbeitsfläche 7 vorzugsweise als Arbeitsebene ausgeführt ist. Der innerhalb der Öffnung liegende Bereich der Arbeitsfläche 7, der zum Aufbau des Objekts 2 verwendet werden kann, als Baufeld 8 bezeichnet wird.

In dem Behälter 5 ist ein in einer vertikalen Richtung V bewegbarer Träger 10 angeordnet, an dem eine Grundplatte 11 angebracht ist, die den Behälter 5 nach unten abschließt und damit dessen Boden bildet. Die Grundplatte 11 kann eine getrennt von dem Träger 10 gebildete Platte sein, die an dem Träger 10 befestigt ist, oder sie kann integral mit dem Träger 10 gebildet sein. Je nach verwendetem Pulver und Prozess kann auf der Grundplatte 11 noch eine Bauplattform 12 angebracht sein, auf der das Objekt 2 aufgebaut wird. Das Objekt 2 kann aber auch auf der Grundplatte 11 selber aufgebaut werden, die dann als Bauplattform dient. In Fig. 1 ist das in dem Behälter 5 auf der Bauplattform 12 zu bildende Objekt 2 unterhalb der Arbeitsfläche 7 in einem Zwischenzustand dargestellt mit mehreren verfestigten Schichten, umgeben von unverfestigt gebliebenem Aufbaumaterial 13.

Die Lasersintervorrichtung 1 enthält weiter einen Vorratsbehälter 14 für ein durch elektromagnetische Strahlung verfestigbares Aufbaumaterial 15 und einen in einer horizontalen Richtung H bewegbaren Beschichter 16 zum Aufbringen des Aufbaumaterials 15 auf das Baufeld 8.

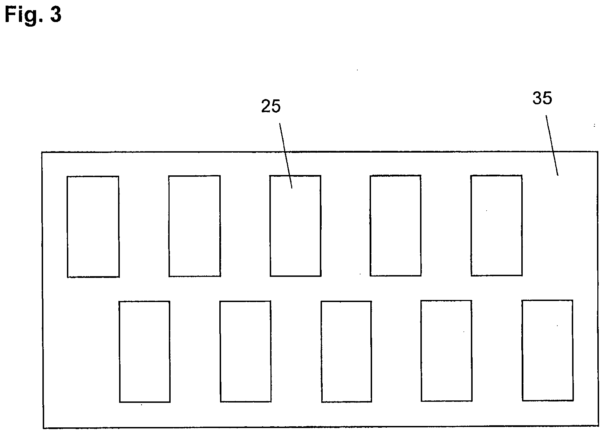

In der Prozesskammer 3 ist ferner eine Strahlungsquelle 21 angeordnet, welche später mit Bezug auf Fig. 3 näher beschrieben wird. Die Strahlungsquelle 21 erzeugt elektromagnetische Strahlung 22, die geeignet ist, beim Auftreffen auf die dem Querschnitt des herzustellenden Objektes entsprechenden Stellen einer auf das Baufeld 8 aufgebrachten Schicht des Aufbaumaterials die Verfestigung des Aufbaumaterials an diesen Stellen zu bewirken. Im Strahlengang der Strahlung 22 ist eine Belichteroptik 20 angeordnet, welche die Strahlung 22 auf das Baufeld 8 fokussiert und dadurch von der Strahlungsquelle 21, die als abzubildendes Objekt dient, ein maßstäblich verkleinertes Bild auf dem Baufeld 8 erzeugt.

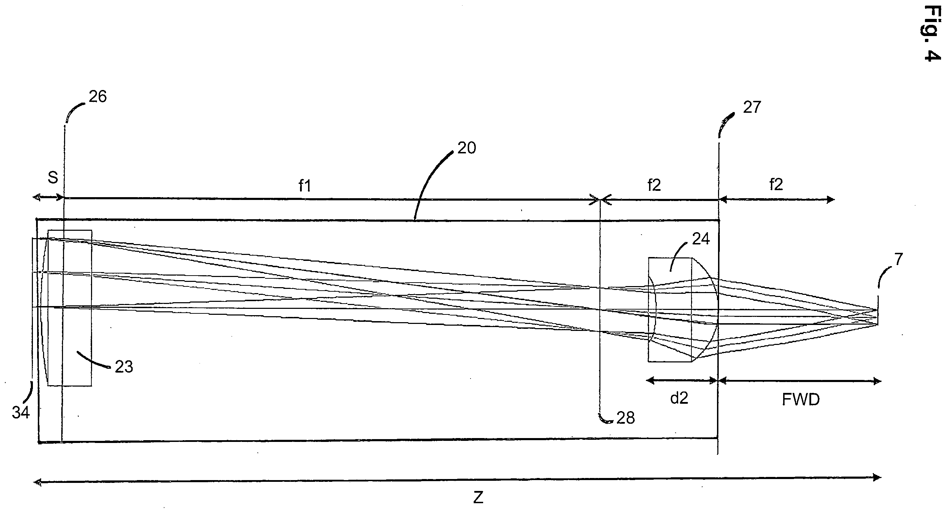

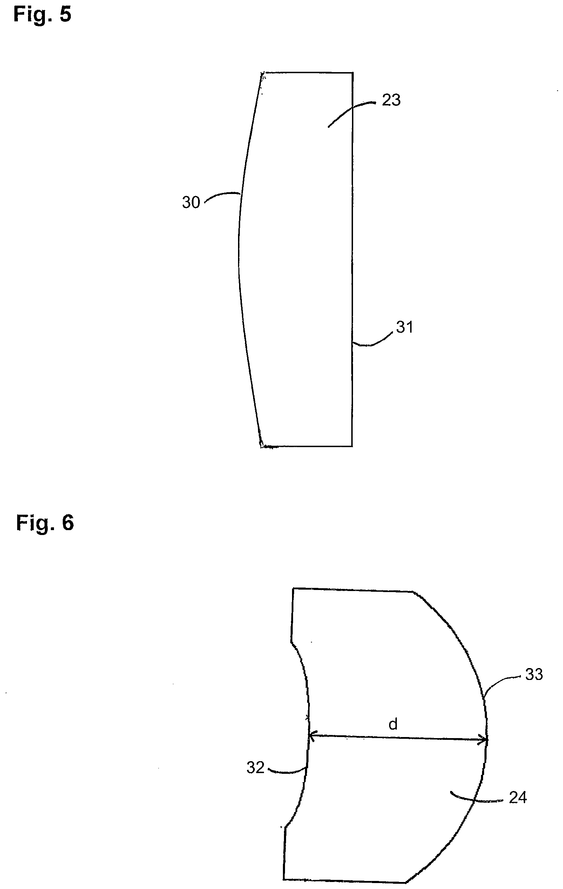

Dazu umfasst die Belichteroptik 20 zumindest eine erste Linse 23 (vgl. Fig. 4 und 5), welche objektseitig, d.h. zur Strahlungsquelle 21 weisend, angeordnet ist, sowie eine zweite Linse 24 (vgl. Fig. 4 und 6), welche bildseitig, d.h. zum Baufeld 8 weisend, angeordnet ist. Objektseitig bezieht sich hierbei auf die Strahlungsquelle als abzubildendes Objekt, nicht auf das mit der Vorrichtung herzustellende dreidimensionale Objekt.

Die Belichteroptik 20 ist so ausgebildet und so in dem Strahlengang der Strahlung 22 angeordnet, dass die elektromagnetische Strahlung 22 im Wesentlichen senkrecht auf die Arbeitsfläche 7 auftrifft, wie später mit Bezug auf Fig. 4-6 näher beschrieben wird. Auch die Belichteroptik 20 selber und die Linsen 23, 24 werden später mit Bezug auf Fig. 4-6 näher beschrieben.

Weiter enthält die Lasersintervorrichtung 1 eine Steuereinheit 29, über die die einzelnen Bestandteile der Vorrichtung 1 in koordinierter Weise zum Durchführen des Bauprozesses gesteuert werden. Die Steuereinheit kann auch teilweise oder ganz außerhalb der Vorrichtung angebracht sein. Die Steuereinheit kann eine CPU enthalten, deren Betrieb durch ein Computerprogramm (Software) gesteuert wird. Das Computerprogramm kann getrennt von der Vorrichtung auf einem Speichermedium gespeichert sein, von dem aus es in die Vorrichtung, insbesondere in die Steuereinheit geladen werden kann.

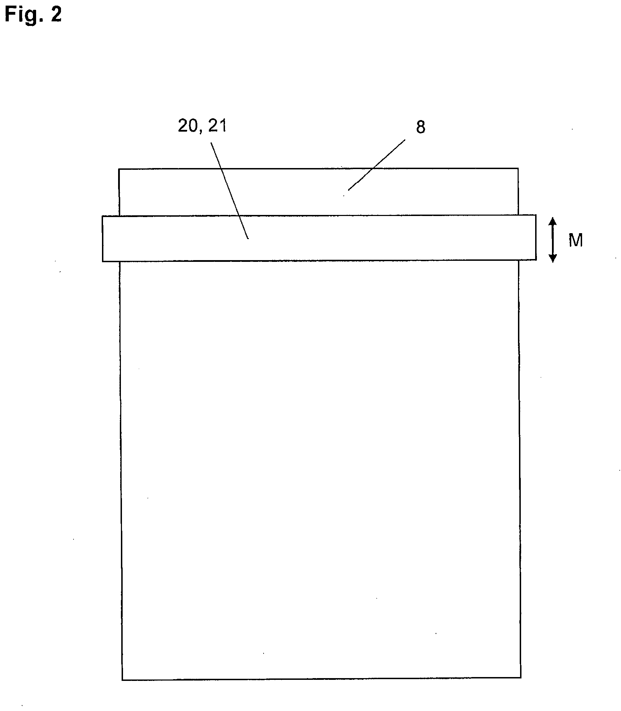

Fig. 2 ist eine schematische Draufsicht auf die Lasersinter- oder Laserschmelzvorrichtung 1 mit der Strahlungsquelle 21 und der Belichteroptik 20, welche in eine horizontale Richtung M über das Baufeld 8 bewegbar angeordnet sind. Die Strahlungsquelle 21 und die Belichteroptik 20 sind dabei vorzugsweise als eine Einheit verfahrbar. Die Strahlungsquelle 21 und die Belichteroptik 20 sind derart ausgestaltet und in der Vorrichtung 1 angeordnet, dass das selektive Verfestigen einer Schicht des Aufbaumaterials 15 in dem Baufeld 8 durch ein- oder mehrmaliges Verfahren der Einheit aus Strahlungsquelle 21 und Belichteroptik 20 in die Richtung M, d.h. über die Länge des Baufelds 8, erfolgt.

Die Strahlungsquelle 21 ist wie in Fig. 3 gezeigt als ein Lasermodul 35 ausgeführt. Das Lasermodul 35 umfasst in Laserarrays 25 gruppierte Laser, welche vorzugsweise als Halbleiterlaser, insbesondere als Halbleiterlaserdioden, weiter vorzugsweise als Vertical Cavity Surface Emitting Laser (VCSEL) oder als Vertical External Cavity Surface Emitting Laser (VECSEL) ausgebildet sind.

Die Laser und die Belichteroptik 20 sind derart ausgebildet und angeordnet, dass zumindest ein Laser, vorzugsweise zumindest zwei Laser eines Laserarrays 25 zu einem Zeitpunkt ein Pixel in der Arbeitsfläche 7 belichten. Ein Pixel ist definiert als das kleinste belichtbare Flächenelement in der Arbeitsfläche 7. In weiter bevorzugter Weise wird das Laserlicht eines ganzen Laserarrays 28 auf ein Pixel in der Arbeitsfläche 7 abgebildet.

Fig. 4 zeigt die Anordnung der Linsen 23, 24 in der Belichteroptik 20. Die Objektebene 34 (die Ebene des abzubildenden Objekts) ist dabei durch die Ebene definiert, in welcher die Laser des Moduls 35 Laserlicht aussenden. Die objektseitige erste Linse 23 ist nahe der Objektebene 34 in dem Strahlengang der Strahlung 22 angeordnet und hat eine erste Hauptebene 26 und eine erste Brennweite $f_1$. Die erste Linse 23 weist, wie aus Fig. 4 und 5 ersichtlich ist, eine sphärische, konvexe Oberfläche 30 auf, welche der Objektebene 34 zugewandt ist, sowie eine ebene Oberfläche 31, welche der Objektebene abgewandt ist, auf. Die erste Linse 23 ist dazu geeignet, die Mittelpunktstrahlen parallel einfallender Lichtbündel (Lichtkegel) in der Brennebene 28, welche in einem Abstand $f_1$ zur Hauptebene 26 der ersten Linse 23 liegt, zu fokussieren, d.h. sie ist eine Sammellinse. Die bildseitige numerische Apertur der ersten Linse 23 ist vorzugsweise kleiner als 0,25, weiter bevorzugt kleiner als 0,15. Dadurch wird eine gute Auflösung der abzubildenden Strahlung 22 erzielt.

Die zweite Linse 24 ist in einem Abstand zur ersten Linse 23 in dem Strahlengang der Strahlung 22 angeordnet. Sie hat eine zweite Hauptebene 27 und eine zweite Brennweite $f_2$. Die zweite Hauptebene ist in einem Arbeitsabstand (free working distance FWD) von der Arbeitsfläche 7 angeordnet.

Die zweite Linse 24 weist, wie aus Fig. 4 und 6 ersichtlich ist, eine asphärische Oberfläche 32 auf, welche zur ersten Linse 23 hin weist, sowie eine sphärische Oberfläche 33, welche zur Arbeitsfläche 7 hin weist. Die sphärische Oberfläche 33 ist konvex und für ihren Krümmungsradius R gilt:

$$R < f_2 * (n-1),$$

wobei n der Brechungsindex des Linsenmaterials der Linse 24 ist, so dass die Brennweite der sphärischen Oberfläche 33 alleine kleiner ist als die gesamte Brennweite $f_2$ der Linse 24.

Die asphärische Oberfläche 32 ist konkav mit einer großen, negativen Brennweite. Die Mittendicke d zwischen der asphärischen Oberfläche 32 und der sphärischen Oberfläche 33 ist größer als ein Viertel, bevorzugt größer als die Hälfte der Brennweite $f_2$. Dadurch liegt die Hauptebene 27 der Linse 23 nahe an der sphärischen Oberfläche 33 und die asphärische Oberfläche 32 liegt zwischen der Hauptebene 27 und der Brennebene 28. Die asphärische Oberfläche kann somit gut verwendet werden um Abbildungsfehler, wie z.B. optische Verzeichnung und Bildfeldwölbung, zu reduzieren.

Die Linsen 23, 24 sind derart in dem Strahlengang der Strahlung 22 angeordnet, dass ihre Brennebenen in einer gemeinsamen Ebene 28 zusammenfallen. Um eine verkleinerte Abbildung der von der Strahlungsquelle 21 ausgesandten Strahlung in der Arbeitsfläche 7 zu erhalten, werden die Linsen 23, 24 so gewählt, dass für ihre Brennweiten $f_1$ und $f_2$ gilt:

$$f_1 > f_2.$$

Der Abbildungsmaßstab ist durch den Quotienten $f_2/f_1$ gegeben und beträgt mindestens 0,05, bevorzugt mindestens 0,1 und besonders bevorzugt mindestens 0,15 und/oder höchstens 1, bevorzugt höchstens 0,5 und besonders bevorzugt höchstens 0,3. Die verkleinerte Abbildung bewirkt eine kleinere Pixelgröße und einen größeren Flächenenergieeintrag in der Arbeitsfläche 7.

Die Brennweite $f_2$ der zweiten Linse 24 ist so zu wählen, dass gilt:

$$f_2 < FWD,$$

wobei FWD die freie Arbeitslänge bezeichnet.

Die Gesamtlänge Z zwischen der Objektebene 34 und der Arbeitsfläche 7 berechnet sich zu

$$Z \geq s + f_1 + 2 * f_2,$$

wobei s den Abstand zwischen Objektebene 34 und der Hauptebene 26 der ersten Linse 23 bezeichnet und sehr klein gewählt werden kann. So kann s beispielsweise etwa 1 mm betragen.

Mit einer so ausgebildeten und angeordneten Belichteroptik kann erreicht werden, dass die elektromagnetische Strahlung 22 im Wesentlichen senkrecht auf die Arbeitsfläche 7 auftrifft. Das bedeutet, dass eine telezentrische Abbildung der Laserelemente der Module auf die Arbeitsfläche stattfindet, bei der jeder Strahlkegel, der von einem Laserelement ausgeht, so auf ein Pixel der Arbeitsfläche gebündelt wird, dass die Mittelachsen des auf die Arbeitsfläche fokussierten Lichtkegels unabhängig von dem Abstand des Laserelements von der optischen Achse der Belichteroptik im Wesentlichen senkrecht zur Arbeitsfläche steht.

Im Folgenden wird der Betrieb der zuvor beschriebenen Lasersinter- oder Laserschmelzvorrichtung 1 beschreiben. Zum Aufbringen einer Schicht des Aufbaumaterials 15 wird zunächst der Träger 10 um eine Höhe abgesenkt, die der gewünschten Schichtdicke entspricht. Durch Verfahren des Beschichters 16 über die Arbeitsfläche 7 wird dann eine Schicht des Aufbaumaterials 15 aufgebracht. Das Aufbringen erfolgt zumindest über den gesamten Querschnitt des herzustellenden Objekts 2, vorzugsweise über das gesamte Baufeld 8, also den Bereich der Arbeitsfläche 7, der durch eine Vertikalbewegung des Trägers abgesenkt werden kann.

Anschließend wird der Querschnitt des herzustellenden Objekts 2 mit Laserstrahlung 22 selektiv bestrahlt, so dass das pulverförmige Aufbaumaterial 15 an den Stellen verfestigt wird, die dem Querschnitt des herzustellenden Objekts 2 entsprechen.

Dazu wird jedes zu belichtende Pixel zu einem Zeitpunkt von zumindest einem Laser, vorzugsweise zumindest zwei Lasern, vorzugsweise von einem ganzen Laserarray 25, bestrahlt. Dabei werden die Strahlungsquelle 21 und die Belichtungsoptik 20 in der Richtung M über das Baufeld 8 bewegt und die Laser der Strahlungsquelle 21 werden entsprechend den zu verfestigenden Stellen geschalten.

Dabei wirkt die Strahlung auf alle zu verfestigenden Stellen der Schicht so ein, dass die Pulverkörner an diesen Stellen durch die durch die Strahlung eingebrachte Wärmeenergie teilweise oder vollständig aufgeschmolzen werden, so dass sie nach einer Abkühlung miteinander verbunden als Festkörper vorliegen.

Die Schritte des Aufbringens einer Schicht des Aufbaumaterials 15 und des selektiven Verfestigens werden solange wiederholt, bis das Objekt 2 fertiggestellt ist und dem Bauraum entnommen werden kann.

Die mit Bezug auf Fig. 1 und 3 beschriebene Strahlungsquelle ist als ein Lasermodul ausgeführt. In einer alternativen Ausführungsform umfasst die Strahlungsquelle zumindest zwei Lasermodule, wobei bevorzugt jedem Modul eine Belichteroptik zugeordnet ist. Die Module können weiter kaskadiert und/oder überlappend angeordnet sein.

Die in Fig. 4 und 5 gezeigte erste Linse 23 umfasst eine sphärische Oberfläche 30 und eine ebene Oberfläche 31. Alternativ kann die Linse 23 auch zwei sphärische, vorzugsweise konvexe, Oberflächen aufweisen.

Die oben beschriebene Belichteroptik umfasst zwei Linsen. Es können jedoch auch noch weitere optische Elemente zum Abbilden der von der Strahlungsquelle ausgesandten Strahlung auf die Arbeitsfläche vorgesehen sein. Ferner kann die erste Linse und/oder die zweite Linse auch als Linsensystem ausgebildet sein, d.h. aus zumindest zwei einzelnen Linsen.

Die Strahlungsquelle kann alternativ auch außerhalb der Prozesskammer angeordnet sein. Dazu weißt die Prozesskammer an ihrer Oberseite dann ein Fenster zum Einkoppeln der Strahlung auf. Ferner kann auch die Belichteroptik außerhalb der Prozesskammer angeordnet sein.

Zusätzlich kann auch eine Strahlungsheizung über der Arbeitsfläche vorgesehen sein zum Aufheizen der Oberfläche der zu verfestigenden Schicht des Aufbaumaterials auf eine Arbeitstemperatur. Alternativ ist es auch möglich, nicht zum Belichten verwendete Laser zum Vorheizen zu verwenden und diese hierzu beispielsweise mit verringerter Leistung zu betreiben.

Auch wenn die vorliegende Erfindung anhand einer Lasersinter- bzw. Laserschmelzvorrichtung beschrieben wurde, ist sie nicht auf das Lasersintern oder Laserschmelzen eingeschränkt. Sie kann auf beliebige Verfahren zum Herstellen eines dreidimensionalen Objektes durch schichtweises Aufbringen und selektives Verfestigen eines pulverförmigen Aufbaumaterials mittels elektromagnetischer Strahlung angewendet werden.

Als Aufbaumaterial wird vorzugsweise ein pulverförmiges Material verwendet, welches dazu geeignet ist, unter Einfluss elektromagnetischer Strahlung ein zusammenhängendes Gebilde zu formen. Hierzu können verschiedene Arten von Pulver verwendet werden, insbesondere Kunststoffpulver, Metallpulver, Keramikpulver, Sand, gefüllte oder gemischte Pulver.

## Patentansprüche

1. Vorrichtung (1) zum Herstellen eines dreidimensionalen Objektes (2) durch selektives schichtweises Verfestigen von Aufbaumaterial (15) an dem Querschnitt des herzustellenden Objektes in der jeweiligen Schicht entsprechenden Stellen mittels Einwirkung elektromagnetischer Strahlung (22),

   wobei die Vorrichtung (1) eine Strahlungsquelle (21) und eine Prozesskammer (3) umfasst, wobei die Strahlungsquelle (21) in der Lage ist, eine elektromagnetische Strahlung (22) auszusenden, die geeignet ist, beim Auftreffen auf die dem Querschnitt des herzustellenden Objektes (2) entsprechenden Stellen einer in einer Arbeitsfläche (7) der Vorrichtung aufgebrachten Schicht des Aufbaumaterials (15) die Verfestigung des Aufbaumaterials (15) an diesen Stellen zu bewirken,
   und die Vorrichtung eine Belichteroptik (20) aufweist mit zumindest einem ersten objektseitigen Linsensystem (23) mit einer ersten Brennweite $f_1$ und einem zweiten bildseitigen Linsensystem (24) mit einer zweiten Brennweite $f_2$ welche in dem Strahlengang der von der Strahlungsquelle (21) ausgesandten Strahlung (22) angeordnet sind, **dadurch gekennzeichnet, dass** die Brennebene des ersten Linsensystems (23) und die Brennebene des zweiten Linsensystems (24) in einer Ebene zwischen den beiden Linsensystemen zusammenfallen, die Brennweite $f_1$ des ersten Linsensystems (23) gleich groß oder größer ist als die Brennweite $f_2$ des zweiten Linsensystems (24), die Belichteroptik (20) so ausgebildet und angeordnet ist, dass die elektromagnetische Strahlung (22) im Wesentlichen senkrecht auf die Arbeitsfläche (7) auftrifft, und die Belichteroptik (21) in der Prozesskammer (3) der Vorrichtung (1) bewegbar angeordnet ist.

2. Vorrichtung nach Anspruch 1, **dadurch gekennzeichnet, dass** das zweite Linsensystem (24) zumindest zwei gekrümmte Oberflächen (32, 33) aufweist, von denen zumindest eine asphärisch und bevorzugt konkav ist.

3. Vorrichtung nach einem der Ansprüche 1 oder 2, **dadurch gekennzeichnet, dass** das zweite Linsensystem (24) zumindest zwei gekrümmte Oberflächen (32, 33) aufweist und dass der minimale Abstand und/oder die Mittendicke (d) zwischen den beiden Oberflächen größer als ein Viertel, bevorzugt größer als die Hälfte der Brennweite $f_2$ ist.

4. Vorrichtung nach einem der Ansprüche 1 bis 3, **dadurch gekennzeichnet, dass** das zweite Linsensystem (24) zumindest zwei gekrümmte Oberflächen (32, 33) aufweist, von denen zumindest eine sphärisch ist und für deren Krümmungsradius R gilt:

$$R < f_2 * (n-1)$$

wobei $f_2$ die Brennweite des zweiten Linsensystems ist und n der Brechungsindex des Linsenmaterials.

5. Vorrichtung nach einem der Ansprüche 1 bis 4, **dadurch gekennzeichnet, dass** das erste Linsensystem (23) zwei sphärische Oberflächen (30, 31) oder eine ebene und eine sphärische Oberfläche aufweist.

6. Vorrichtung nach einem der Ansprüche 1 bis 5, **dadurch gekennzeichnet, dass** der Quotient $f_2/f_1$ einem gewählten Abbildungsmaßstab entspricht.

7. Vorrichtung nach einem der Ansprüche 1 bis 6, **dadurch gekennzeichnet, dass** der Quotient $f_2/f_1$ einen Wert von mindestens 0,05, bevorzugt mindestens 0,1 und besonders bevorzugt mindestens 0,15 und/oder von höchstens 1, bevorzugt höchstens 0,5 und besonders bevorzugt höchstens 0,3 aufweist.

8. Vorrichtung nach einem der Ansprüche 1 bis 7, **dadurch gekennzeichnet, dass** mindestens eines, bevorzugt jedes, der beiden Linsensysteme (23, 24) aus einer einzelnen Linse gebildet ist.

9. Vorrichtung nach einem der Ansprüche 1 bis 8, **dadurch gekennzeichnet, dass** zumindest eines der Linsensysteme (23, 24) aus zumindest zwei Linsen gebildet ist.

10. Vorrichtung (1) nach einem der Ansprüche 1 bis 9, **dadurch gekennzeichnet, dass** die Strahlungsquelle (21) von Lasern, insbesondere VCSELn, gebildet ist, welche in Modulen (35) gruppiert sind, wobei jedes Modul vorzugsweise zumindest zwei Laser-Arrays umfasst.

11. Vorrichtung (1) nach einem der Ansprüche 1 bis 10, **dadurch gekennzeichnet, dass** die Brennweite $f_2$ des zweiten Linsensystems (24) kleiner als ein minimaler freier Arbeitsabstand (FWD) ist.

12. Vorrichtung nach einem der Ansprüche 1 bis 11, **dadurch gekennzeichnet, dass** die Strahlungsquelle (21) und/oder eine zwischen der Strahlungsquelle und der Belichteroptik angeordnete weitere Belichteroptik derart ausgebildet sind, dass die Strahlung auf das erste Linsensystem (23) im Wesentlichen senkrecht auftrifft.

13. Verwendung einer Vorrichtung (1) nach einem der Ansprüche 1 bis 12 zur Herstellung eines dreidimensionalen Objektes (2) durch selektives schichtweises Verfestigen von Aufbaumaterial (15) an dem Querschnitt des herzustellenden Objektes (2) in der jeweiligen Schicht entsprechenden Stellen mittels Einwirkung elektromagnetischer Strahlung (22).

## Claims

1. A device (1) for producing a three-dimensional object (2) by selectively solidifying building material (15), layer by layer, at positions that correspond to the cross-section of the object to be produced in the respective layer by means of electromagnetic radiation (22),

wherein the device (1) comprises a radiation source (21) and a process chamber (3), the radiation source (21) being capable of emitting an electromagnetic radiation (22) that is suited to cause solidification of the building material (15) at positions of a layer of the building material (15) applied in a working surface (7) of the device, which positions correspond to the cross-section of the object (2) to be produced, when impinging on those positions,

and wherein the device comprises an exposure optics (20) having at least a first object-sided lens system (23) having a first focal length $f_1$ and a second image-sided lens system (24) having a second focal length $f_2$, which lens systems are arranged in the beam path of the radiation (22) emitted by the radiation source (21), **characterized in that**

the focal plane of the first lens system (23) and the focal plane of the second lens system (24) coincide in a plane between the two lens systems,

the focal length $f_1$ of the first lens system (23) is equal to or greater than the focal length $f_2$ of the second lens system (24),

the exposure optics (20) is designed and arranged such that the electromagnetic radiation (22) is incident substantially perpendicular on the working surface (7), and

the exposure optics (21) is movably arranged in the process chamber (3) of the device (1).

2. The device according to claim 1, **characterized in that** the second lens system (24) comprises at least two curved surfaces (32, 33), wherein at least one of them is aspheric and preferably concave.

3. The device according to one of claims 1 or 2, **characterized in that** the second lens system (24) comprises at least two curved surfaces (32, 33) and that the minimum distance and/or the center thickness (d) between the two surfaces is greater than a quarter, preferably greater than half the focal length $f_2$.

4. The device according to one of claims 1 to 3, **characterized in that** the second lens system (24) comprises at least two curved surfaces (32, 33), wherein at least one of them is spherical and for whose radius of curvature R applies:

$$R < f_2 * (n - 1)$$

wherein $f_2$ is the focal length of the second lens system and n is the refractive index of the lens material.

5. The device according to one of claims 1 to 4, **characterized in that** the first lens system (23) comprises two spherical surfaces (30, 31) or a planar and a spherical surface.

6. The device according to one of claims 1 to 5, **characterized in that** the quotient $f_2/f_1$ corresponds to a selected image scale.

7. The device according to one of claims 1 to 6, **characterized in that** the quotient $f_2/f_1$ has a value of at least 0.05, preferably at least 0.1 and more preferably at least 0.15 and/or of at most 1, preferably at most 0.5 and more preferably at most 0.3.

8. The device according to one of claims 1 to 7, **characterized in that** at least one, preferably each, of the two lens systems (23, 24) is formed by a single lens.

9. The device according to one of claims 1 to 8, **characterized in that** at least one of the lens systems (23, 24) is composed of at least two lenses.

10. The device (1) according to one of claims 1 to 9, **characterized in that** the radiation source (21) is formed by lasers, in particular VCSELs, which are grouped as modules (35), each module preferably comprising at least two laser arrays.

11. The device (1) according to one of claims 1 to 10, **characterized in that** the focal length $f_2$ of the second lens system (24) is smaller than a minimum free working distance (FWD).

12. The device (1) according to one of claims 1 to 11, **characterized in that** the radiation source (21) and/or a further exposure optics arranged between the radiation source and the exposure optics are configured such that the radiation is incident on the first lens system (23) substantially perpendicular.

13. Use of a device (1) according to one of claims 1 to 12 for producing a three-dimensional object (2) by means of selectively solidifying building material (15), layer by layer, at positions that correspond to the cross-section of the object (2) to be produced in the respective layer by means of electromagnetic radiation (22).

**Revendications**

1. Dispositif (1) de fabrication d'un objet tridimensionnel (2) par solidification sélective par couche d'un matériau de construction (15) à des positions correspondant à la section transversale de l'objet à fabriquer dans la couche respective au moyen de l'action d'un rayonnement électromagnétique (22),

dans lequel le dispositif (1) comprend une source de rayonnement (21) et une chambre de traitement (3), la source de rayonnement (21) étant en mesure d'émettre un rayonnement électromagnétique (22) qui est approprié pour provoquer, lors de l'impact sur les positions correspondant à la section transversale de l'objet à fabriquer (2) d'une couche du matériau de construction (15) appliquée dans une surface de travail (7) du dispositif, la solidification du matériau de construction (15) à ces positions,
et le dispositif présente une optique d'exposition (20) avec au moins un premier système de lentilles côté objet (23) avec une première distance focale $f_1$ et un deuxième système de lentilles côté image (24) avec une deuxième distance focale $f_2$ qui sont disposés dans le trajet de faisceau du rayonnement (22) émis par la source de rayonnement (21), **caractérisé en ce que** le plan focal du premier système de lentilles (23) et le plan focal du deuxième système de lentilles (24) coïncident dans un plan entre les deux systèmes de lentilles, la distance focale $f_1$ du premier système de lentilles (23) est supérieure ou égale à la distance focale $f_2$ du deuxième système de lentilles (24), l'optique d'exposition (20) est réalisée et disposée de telle sorte que le rayonnement électromagnétique (22) frappe sensiblement perpendiculairement la surface de travail (7), et l'optique d'exposition (21) est disposée de manière déplaçable dans la chambre de traitement (3) du dispositif (1).

2. Dispositif selon la revendication 1, **caractérisé en ce que** le deuxième système de lentilles (24) présente au moins deux surfaces courbes (32, 33), dont au moins une est asphérique et de préférence concave.

3. Dispositif selon l'une quelconque des revendications 1 ou 2, **caractérisé en ce que** le deuxième système de lentilles (24) présente au moins deux surfaces courbes (32, 33) et **en ce que** la distance minimale et/ou l'épaisseur centrale (d) entre les deux surfaces est supérieure à un quart, de préférence supérieure à la moitié de la distance focale $f_2$.

4. Dispositif selon l'une quelconque des revendications 1 à 3, **caractérisé en ce que** le deuxième système de lentilles (24) présente au moins deux surfaces courbes (32, 33), dont au moins une est sphérique et pour le rayon de courbure R de laquelle il s'applique :

$$R < f_2 * (n-1)$$

$f_2$ étant la distance focale du deuxième système de lentilles et n l'indice de réfraction du matériau de lentilles.

5. Dispositif selon l'une quelconque des revendications 1 à 4, **caractérisé en ce que** le premier système de lentilles (23) présente deux surfaces sphériques (30, 31) ou une surface plane et une surface sphérique.

6. Dispositif selon l'une quelconque des revendications 1 à 5, **caractérisé en ce que** le quotient $f_2/f_1$ correspond à une échelle de reproduction choisie.

7. Dispositif selon l'une quelconque des revendications 1 à 6, **caractérisé en ce que** le quotient $f_2/f_1$ présente une valeur d'au moins 0,05, de préférence d'au moins 0,1 et de manière particulièrement préférée d'au moins 0,15 et/ou d'au plus 1, de préférence d'au plus 0,5 et de manière particulièrement préférée d'au plus 0,3.

8. Dispositif selon l'une quelconque des revendications 1 à 7, **caractérisé en ce qu'**au moins un, de préférence chacun, des deux systèmes de lentilles (23, 24) est formé à partir d'une lentille individuelle.

9. Dispositif selon l'une quelconque des revendications 1 à 8, **caractérisé en ce qu'**au moins un des systèmes de lentilles (23, 24) est formé à partir d'au moins deux lentilles.

10. Dispositif (1) selon l'une quelconque des revendications 1 à 9, **caractérisé en ce que** la source de rayonnement (21) est formée par des lasers, en particulier des VCSELn, qui sont groupés en modules (35), chaque module comprenant de préférence au moins deux réseaux de lasers.

11. Dispositif (1) selon l'une quelconque des revendications 1 à 10, **caractérisé en ce que** la distance focale $f_2$ du deuxième système de lentilles (24) est inférieure à une distance de travail libre minimale (FWD).

12. Dispositif selon l'une quelconque des revendications 1 à 11, **caractérisé en ce que** la source de rayonnement (21) et/ou une autre optique d'exposition disposée entre la source de rayonnement et l'optique d'exposition sont réalisées de telle sorte que le rayonnement frappe sensiblement perpendiculairement le premier système de lentilles (23).

13. Utilisation d'un dispositif (1) selon l'une quelconque des revendications 1 à 12 pour la fabrication d'un objet tridimensionnel (2) par solidification sélective par couche d'un matériau de construction (15) à des positions correspondant à la section transversale de l'objet à fabriquer (2) dans la couche respective au moyen de l'action d'un rayonnement électromagnétique (22).

## Fig. 1

**Fig. 2**

Fig. 3

**Fig. 4**

**Fig. 5**

23

30

31

**Fig. 6**

33

d

32

24

**Fig. 7**

(Stand der Technik)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2015091485 A